(19) Europäisches Patentamt / European Patent Office / Office européen des brevets

(11) **EP 1 895 310 B1**

(12) **FASCICULE DE BREVET EUROPEEN**

(45) Date de publication et mention
de la délivrance du brevet:
**14.06.2017 Bulletin 2017/24**

(51) Int Cl.:
*G01R 29/08* (2006.01)      *H01P 3/123* (2006.01)

(21) Numéro de dépôt: **07113026.4**

(22) Date de dépôt: **24.07.2007**

(54) **Dispositif de génération d'un rayonnement hyperfréquence, et procédé de test de vulnerabilité aux rayonnenments haute énergie**

Vorrichtung zur Erzeugung von Mikrowellenstrahlung, und Verfahren zum Testen der Störempfindlichkeit durch Hochenergiestrahlung

Device for the generation of microwave radiation, and method of testing the vulnérability to high-energy radiations

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **27.07.2006 FR 0606883**

(43) Date de publication de la demande:
**05.03.2008 Bulletin 2008/10**

(73) Titulaire: **THALES**
**92400 Courbevoie (FR)**

(72) Inventeurs:
• **Canal, Yves**
**92160 Antony (FR)**
• **Durand, Alain**
**92250 La Garenne Colombes (FR)**

(74) Mandataire: **Lucas, Laurent Jacques**
**Marks & Clerk France**
**Conseils en Propriété Industrielle**
**Immeuble Visium**
**22, Avenue Aristide Briand**
**94117 Arcueil Cedex (FR)**

(56) Documents cités:
**US-A1- 2003 051 666**

• **GIRAUD H ET AL: "UTILISATION D'UNE CELLULE TEM POUR ESSAIS EN COMPATIBILITE ELECTROMAGNETIQUE (IEM, CEM)" ONDE ELECTRIQUE, EDITIONS CHIRON S.A. PARIS, FR, vol. 70, no. 2, 1 mars 1990 (1990-03-01), pages 21-26, XP000102111 ISSN: 0030-2430**

**EP 1 895 310 B1**

**Description**

La présente invention concerne un dispositif de génération d'un rayonnement hyperfréquence et un procédé de test de vulnérabilité aux rayonnements haute énergie. L'invention s'applique notamment pour tester la tenue fonctionnelle aux rayonnements hyperfréquence de matériels.

Actuellement, la caractérisation de matériels aux rayonnements hyperfréquence est effectuée dans des chambres anéchoïdes ou des chambres dites réverbérantes. Le volume interne de ces chambres atteint plusieurs mètres cubes. De ce fait, l'énergie hyperfréquence rayonnée destinée à tester les matériels est dispersée dans le volume de ces chambres et il n'est pas possible de placer ceux-ci dans des champs électriques de plus de 1 kilovolt par mètre dans la bande par exemple comprise entre 1 GHz et 18 GHz lorsque l'amplification de l'onde rayonnée ne dépasse pas 1 kilowatt dans cette bande de fréquences.

Augmenter l'ambiance électromagnétique déposée sur la cible à tester pourrait se faire à l'aide d'amplificateurs plus puissants, mais ceux-ci n'existent pas dans le commerce et la réalisation d'un amplificateur spécifique est très coûteuse. Par ailleurs, les travaux antérieurs dans le domaine de la caractérisation de la vulnérabilité, notamment fonctionnelle, de matériels face aux ondes hyperfréquence de forte puissance ont montré que les tests ne devenaient riches en résultat que lorsqu'on pouvait atteindre, voire dépasser, une ambiance de la classe de 10 kilovolts par mètre. Le document US 2003/0051666 A1 divulgue un dispositif de génération d'un rayonnement hyperfréquence vers un cible comportant au moins un guide d'onde et étant équipé de lamelles conductrices.

Un but de l'invention est notamment de pallier les inconvénients précités. A cet effet, l'invention a pour objet un dispositif de génération d'un rayonnement hyperfréquence comme décrit dans la revendication 1. Les lamelles sont par exemple à une même distance d les unes par rapport aux autres.

Dans un mode de réalisation particulier, le rayonnement étant émis dans une bande de fréquences donnée, la distance d est par exemple inférieure à la demi-longueur d'onde de la fréquence la plus élevée de la bande. La largeur intérieure L du guide d'onde est par exemple supérieure ou égale à la demi-longueur d'onde de la fréquence la plus basse de la bande. Avantageusement, l'ouverture d'une lamelle peut commencer du côté de l'entrée du guide par un évasement. Cet évasement commence par exemple à une distance donnée Le de l'entrée du guide.

L'ouverture d'une lamelle se ferme par exemple par un évasement du côté de la sortie du guide.

Le guide d'onde peut être formé par l'assemblage de deux demi-guide d'onde en forme de U.

Avantageusement, les lamelles peuvent être fixées par paires sur les parois latérales du guide, une paire de lamelles ayant la forme d'un U. Une paire en U comporte par exemple deux demi-lamelles, une lamelle étant formée par l'assemblage des deux demi-guide d'onde.

Dans des modes de réalisation possible, l'ouverture d'une lamelle est sensiblement égale à la moitié, ou au tiers, de la largeur interne L du guide d'onde.

Avantageusement, le guide d'onde comporte par exemple une trappe d'accès fermant une ouverture percée sur une face longitudinale du guide.

L'entrée du guide est par exemple reliée, par un guide de transition évasé, à un circuit d'amenée de l'onde formant le rayonnement hyperfréquence. De même, la sortie du guide peut être reliée, par un guide de transition évasé, à un circuit du rayonnement hyperfréquence.

L'invention a également pour objet un procédé de test de vulnérabilité d'une cible à un rayonnement hyperfréquence, la cible étant placée dans l'espace disponible d'un dispositif selon l'invention tel que précédemment décrit. Avantageusement, la cible peut être un matériel en fonctionnement.

D'autres caractéristiques et avantages de l'invention apparaîtront à l'aide de la description qui suit faite en regard de dessins annexés qui représentent :

- la figure 1, par une vue en coupe transversale un exemple de réalisation d'un dispositif selon l'invention ;
- la figure 2, une vue d'ensemble d'un exemple de réalisation d'un dispositif selon l'invention ;
- la figure 3, une illustration du rayonnement hyperfréquence à l'intérieur d'un dispositif selon l'invention ;
- la figure 4, un exemple de réalisation de lamelles équipant un dispositif selon l'invention ;
- les figures 5a et 5b, des exemples de fabrication d'un dispositif selon l'invention.

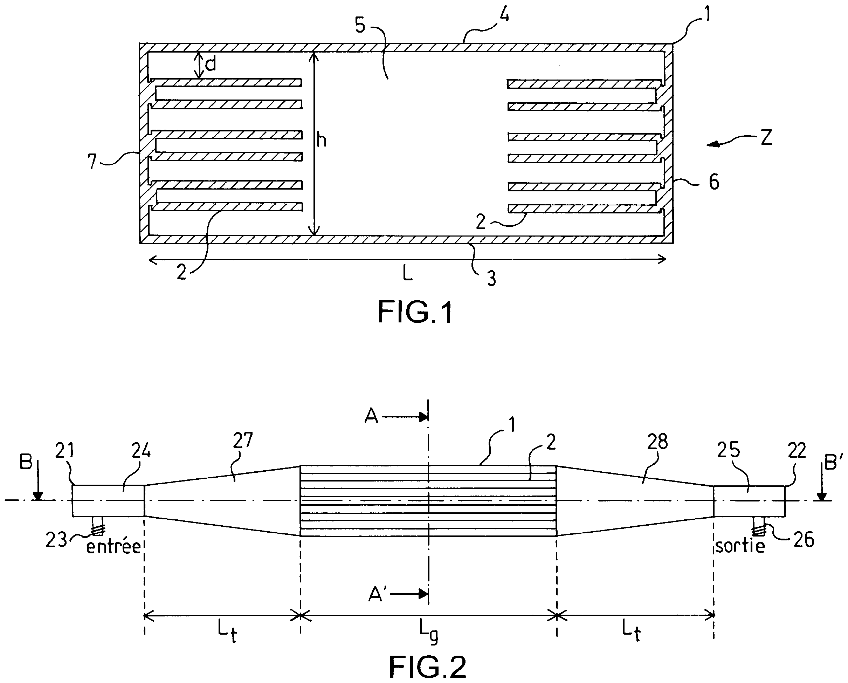

La figure 1 illustre par une vue en coupe transversale un exemple de réalisation d'un dispositif de génération de rayonnement hyperfréquence selon l'invention. Le dispositif comporte un guide d'onde rectangulaire 1 de largeur L et de hauteur h, le guide étant formé de deux parois longitudinales 3, 4 de largeur L et de deux parois latérales 6, 7 de hauteur h.

Une onde hyperfréquence se propage à l'intérieur de ce guide selon une direction perpendiculaire au plan de coupe, le mode transmis étant le mode transverse électrique TE. Des lamelles conductrices 2 sont disposées à l'intérieur du guide 1. Plus particulièrement, les lamelles sont placées parallèlement aux parois longitudinales 3, 4. Les lamelles n'occupent pas toutes la largeur du guide de façon à laisser un espace libre 5 dans lequel peut être disposé un matériel à tester.

De préférence les lamelles 2 sont toutes disposées à la même distance d les unes par rapport aux autres. Cette distance d est par exemple inférieure à la demi-longueur d'onde la plus petite, c'est-à-dire celle correspondant à la fréquence la plus haute. En effet, pour ne pas sous-échantillonner les lignes de champ, la hauteur entre les lamelles doit être inférieure à la demi-longueur d'onde la plus petite.

Ainsi, si la bande de fréquence transmise à l'intérieur du guide est comprise par exemple entre 1 GHz et 18 GHz, la distance d vérifie la relation suivante :

$$d < \frac{\lambda_{18}}{2} \qquad\qquad\qquad (1)$$

où $\lambda_{18}$ est la longueur d'onde de la fréquence la plus basse, par exemple 18 GHz.

La figure 2 présente une vue suivant Z d'un dispositif selon l'invention, la figure 1 étant une vue en coupe selon AA'. Le dispositif comporte le guide 1 illustré par la figure 1. Les lamelles ont été représentées bien qu'elle ne soit pas visibles selon Z car cachées par la paroi latérale 6. Le dispositif comporte une entrée 21 et une sortie 22. L'entrée 21 réalise par exemple l'interface entre un guide de type coaxial 23 et un guide rectangulaire 24. De même la sortie réalise par exemple l'interface entre un guide d'onde rectangulaire 25 et un guide coaxial 26. Un guide évasé 27 permet de faire la transition entre le guide rectangulaire d'entrée 24 et le guide rectangulaire 1 à lamelles. Un guide évasé permet de son côté de faire la transition entre le guide à lamelle et le guide de sortie 25. Les guides évasés 27, 28 permettant de faire la transition sont généralement appelés selon l'expression anglo-saxonne taper.

La longueur $L_g$ du guide 1 à lamelles dépend du type de matériel à tester. Cette longueur peut être de l'ordre de 1 mètre par exemple. La largeur L du guide 1 dépend de la largeur des fréquences transmise à l'intérieur, notamment de la largeur de bande. Typiquement, la largeur L peut varier entre 10 et 20 centimètres. La hauteur h du guide dépend de sa largeur, typiquement h = L/2.

Pour pouvoir conduire toutes les fréquences de la bande de test, la largeur L du guide, plus précisément sa largeur interne, doit être plus importante que la demi-longueur d'onde la plus grande $\lambda_1$ correspondant à la fréquence la plus basse, par exemple 1 GHz. Ainsi :

$$L > \frac{\lambda_1}{2} \qquad\qquad\qquad (2)$$

Dans ce cas, l'espace disponible 5 pour placer un matériel sous test peut être représenté par un volume ayant une longueur l'ordre de 1 m, voire plus, et une section de l'ordre de 50 cm$^2$ par exemple. La longueur $L_t$ des transitions 27, 28 est par exemple de l'ordre de 3. $\lambda_{18}$, permettant ainsi une adaptation large bande entre les guides d'entrée et de sortie et le guide 1 à lamelles, $\lambda_{18}$ étant la longueur d'onde de la fréquence transmise la plus haute.

Pour tester un matériel, celui-ci est placé dans l'espace disponible 5 à l'intérieur du guide à lamelle puis une onde hyperfréquence, dont la fréquence est comprise dans la bande de test, est envoyée dans l'entrée 21 du dispositif. Cette onde peut être amenée par un guide coaxial 23. Ainsi, l'injection de stimuli électromagnétique dans le guide d'onde 1 à lamelles est effectuée au niveau de l'entrée 21. Une mesure de taux d'onde stationnaire (TOS) permet de connaître la fraction de la puissance qui est effectivement entrée dans le guide d'onde 1. La puissance est émise, via un guide coaxial 23 par exemple, par un amplificateur non représenté. La mesure de la puissance en sortie 22 permet alors de connaître la valeur exacte de l'énergie absorbée par le matériel testé, aux mesures de calibration près comme il sera vu par la suite.

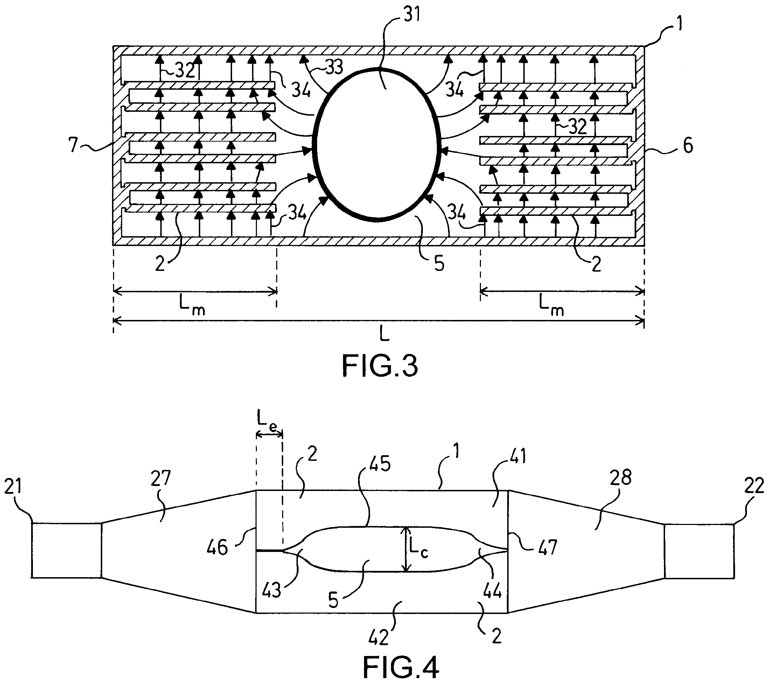

La figure 3 illustre un cas où un matériel 31 est placé sous test à l'intérieur du guide 1 à lamelles. La représentation est une vue en coupe selon AA' comme pour la figure 1, le matériel 31 étant aussi représenté en coupe. Le mode de transmission étant électrique transverse TE, les lignes de champ électrique 32, 33, 34 se situent dans le plan de coupe, perpendiculaires à la direction de transmission de l'onde. Les essais et simulations réalisés par la Demanderesse ont montré que les lignes de champs 33 au voisinage du matériel 31 sont analogues à celles qui seraient créés avec une onde plane en espace libre, malgré le confinement de l'énergie. Ainsi, avantageusement, bien que l'espace soit confiné la configuration du champ 33 qui agresse le matériel 31, en fait la cible, est analogue à ce qui se produirait en espace libre mais avec une forte concentration d'énergie. En effet une grande partie de l'énergie transmise par les guides d'amenée 23, 24, 27 est confinée dans l'espace disponible entre les lamelles. En d'autres termes, la quasi-totalité de la puissance fournie par un amplificateur circule dans cet espace disponible pour se concentrer sur le matériel à tester.

La section interne utile du guide d'onde 1 à lamelle étant de l'ordre de 50 cm$^2$, cela permet d'atteindre des densités de puissance de l'ordre de 20 watts par centimètre carré autour des matériels à tester avec un amplificateur de 1 Kilowatt, identique à ceux utilisé notamment en chambres anéchoïdes ou réverbantes.

La figure 3 montre les lignes de champ électrique 32, 33, 34. Les lignes de champ magnétique étant perpendiculaires, elles ne peuvent être représentées mais elles sont aussi présentes dans une configuration d'espace libre autour du matériel 31.

La configuration des lignes de champs 33 reste analogue à celle d'un espace libre pour toute la bande de fréquences de test, par exemple la bande de 1 GHz à 18 GHz, le guide d'onde 1 sans les lamelles étant notamment dimensionné pour le passage d'une onde électromagnétique à 1 GHz.

Entre les lamelles 2, les lignes de champ électrique 32 restent parallèles entre-elles. Une faible partie de l'énergie hyperfréquence passe à l'intérieur de ces lamelles 2. Les lignes de champs 34 au voisinage de l'espace libre assurent la continuité avec les lignes d'espace libre 33.

La présence des lamelles 2 à l'intérieur du guide 1 et au voisinage du matériel à tester 31 a notamment pour but, tout en confinant l'énergie du stimuli électromagnétique, de garantir que la disposition des champs électriques dans l'enceinte réduite formée du guide 1 s'apparente à celle qu'auraient ces champs si l'illumination électromagnétique s'effectuait en onde plane dans l'espace libre.

L'ambiance électromagnétique autour du matériel à tester 31 peut atteindre la classe de 10 kilovolts par mètre. Avantageusement, le calcul de puissance à champ électrique peut s'effectuer avec une impédance voisine de celle d'espace libre puisque la configuration des champs dans le guide d'onde 1 à lamelles est analogue à celle de l'espace libre.

Avantageusement, la puissance réellement absorbée par les matériels testés est parfaitement connue puisqu'elle est égale à la différence entre la puissance entrante et celles sortantes, après calibration de l'ensemble du dispositif en particulier au niveau des interfaces.

La longueur $L_m$ des lamelles à partir des parois latérales 6, 7, dans un plan de coupe transversal, peut être la même pour toutes les lamelles, comme illustré par les figures 1 et 3. Cette longueur $L_m$ peut être par exemple égale à 1/4 ou 1/3 de la largeur L du guide, l'ouverture d'une lamelle étant alors respectivement égale à L/2 ou L/3. Les longueurs $L_m$ peuvent ne pas être uniformes. Leurs extrémités en regard de l'espace disponible 5 peuvent par exemple présenter un arc de cercle.

La figure 4 présente une autre vue d'un dispositif selon l'invention. En se référant à la figure 2, cette vue est une vue en coupe selon BB', en vue de dessus. Plus particulièrement, la figure 4 présente une forme possible d'une lamelle 2, celle-ci étant vue de dessus. Cette lamelle peut être réalisée en une seule partie ou en deux parties symétriques 41, 42 par exemple. Un espace est prévu dans la lamelle définissant l'espace disponible 5 décrit précédemment pour accueillir les matériels à tester.

Avantageusement, l'exemple de réalisation de la figure 4 prévoit des zones de transition 43, 44 dans les lamelles 2. Ces zones de transitions forment des « tapers » qui prolongent les « tapers » 27, 28 reliant l'entrée ou la sortie au guide d'onde 1. Une lamelle comporte donc une ouverture 45 qui s'évase dans le sens de la longueur. Plus précisément, en entrée 46 du guide 1 la lamelle s'étend par exemple sur toute la largeur du guide sur une longueur Le, puis elle comporte une ouverture qui s'évase pour conserver une largeur constante $L_c$ sur une longueur donnée du guide. Un autre évasement 44 de l'ouverture de la lamelle commence à partir de la sortie 47 du guide jusqu'à la rencontre avec la partie de largueur constante.

Les évasements 43, 44 de l'ouverture des lamelles en prolongeant les « tapers » 27, 28 d'entrée et de sortie permettent notamment d'éviter les réflexions parasites lors des changements de mode de propagation.

En pratique, c'est à l'intérieur de la longueur $L_c$ que peut être placé un matériel à tester. Les transitions 43, 44 réalisées par les évasements des ouvertures internes 45 des lamelles 2 permet notamment d'éviter des réflexions parasites lors des changements de mode de propagation.

Dans un mode de réalisation particulier, les évasements 43, 44 pourrait être supprimés. L'ouverture 45 d'une lamelle, de largueur constante $L_c$ par exemple, débuterait alors dès l'entrée 46 du guide 1 pour continuer jusqu'à la sortie 47 du guide.

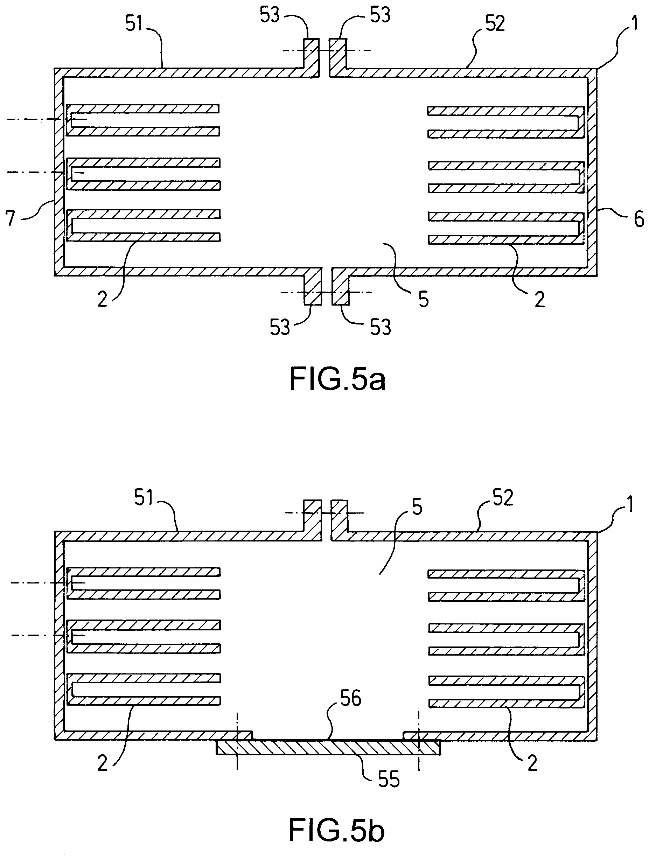

Les figures 5a et 5b présentent un exemple de réalisation possible d'un dispositif selon l'invention. Les représentations des figures 5a et 5b sont des vues en coupes transversales prise dans deux sections différentes.

La figure 5a illustre notamment un mode de réalisation possible du guide d'onde 1 et un mode de fixation possible des lamelles 2. En ce qui concerne le guide d'onde 1, celui-ci peut être réalisé par l'assemblage de deux demi-guides 51, 52 de forme identique et dont la section sur la figure 5a est en U. Chaque demi-guide 51, 52 comporte des rebords 53 permettant de les fixer entre eux. A cet effet, les rebords 53 sont par exemple percés pour laisser le passage d'un boulon de fixation. Les trous peuvent aussi être taraudés pour permettre une fixation par vis.

Les lamelles 2 peuvent par exemple être réalisée par paires, une paire de lamelle ayant la forme d'un U. Le fond du U formant les deux lamelles 2 est fixé sur une paroi transversale 6, 7 du guide. La fixation peut se faire par vissage. Dans ce cas, en se référant à la figure 4, une lamelle 2 est formée de deux demi-lamelle 41, 42, une paire comportant deux demi-lamelle. Les lamelles sont ensuite constituées par l'assemblage des deux demi-parties, chaque partie comportant un demi-guide d'onde 51, 52 équipé de ses paires de demi-lamelles 41, 42.

Un avantage de ce mode de réalisation et de fixation des lamelles tel qu'illustré par les figures 5a et 5b est la souplesse de réalisation. En effet, il est ainsi aisé de modifier la forme des lamelles soit pour des raisons radioélectriques, soit en fonction des dimensions du matériel à tester.

Un avantage de l'assemblage en deux demi-guides d'onde est que l'endroit d'interruption de la conduction électrique, au niveau de la jonction des deux demi-guides, correspond à la zone de courant nul d'une part, et d'autre part cette zone peut recevoir une trappe d'accès 55 comme illustré sur la figure 5b. Cette trappe d'accès permet notamment de n'inclure dans le guide d'onde 1 à lamelles qu'une partie d'un matériel à tester. Avantageusement, cela peut permettre de protéger des rayonnements hyperfréquence les connexions qui permettent de faire fonctionner le matériel comme s'il était en situation opérationnelle réelle. Au niveau de la trappe 55, le guide 1 possède une ouverture 56, percée sur une face longitudinale 3 permettant de laisser passer un matériel. La trappe est par exemple vissée sur le guide.

## Revendications

1. Dispositif de génération d'un rayonnement hyperfréquence vers une cible (31), comportant au moins un guide d'onde rectangulaire (1) formé de deux parois longitudinales (3, 4) et de deux parois latérales (6, 7), guidant le rayonnement hyperfréquence, équipé de lamelles conductrices intérieures (2) placées parallèlement aux parois longitudinales (3, 4), les lamelles conductrices ayant une ouverture (45) pour former un espace disponible (5) apte à accueillir la cible (1).

2. Dispositif selon la revendication 1, rayonnement étant émis dans une bande de fréquences donnée, la distance (d) entre les lamelles (2) étant inférieure à la demi-longueur d'onde ($\lambda_{18}$) de la fréquence la plus élevée de la bande.

3. Dispositif selon l'une quelconque des revendications précédentes, le rayonnement étant émis dans une bande de fréquences donnée, la largeur intérieure (L) du guide d'onde (1) étant supérieure ou égale à la demi-longueur d'onde ($\lambda_1$) de la fréquence la plus basse de la bande.

4. Dispositif selon l'une quelconque des revendications précédentes, l'ouverture (45) d'une lamelle commençant du côté de l'entrée (46) du guide (1) par un évasement (43).

5. Dispositif selon la revendication 4, l'évasement (43) commençant à une distance donnée ($L_e$) de l'entrée (46) du guide.

6. Dispositif selon l'une quelconque des revendications précédentes, l'ouverture (45) d'une lamelle se fermant par un évasement (44) du côté de la sortie du guide (1).

7. Dispositif selon l'une quelconque des revendications précédentes, le guide d'onde (1) étant formé par l'assemblage de deux demi-guide d'onde (51, 52) en forme de U.

8. Dispositif selon l'une quelconque des revendications précédentes, les lamelles (2) étant fixées par paires sur les parois latérales (6, 7) du guide (1), une paire de lamelles ayant la forme d'un U.

9. Dispositif selon les revendications 7 et 8, une paire en U comportant deux demi-lamelles (41, 42), une lamelle (2) étant formée par l'assemblage des deux demi-guide d'onde (51, 52).

10. Dispositif selon l'une quelconque des revendications précédentes, l'ouverture (45) d'une lamelle étant sensiblement égale à la moitié de la largeur interne (L) du guide d'onde (1).

11. Dispositif selon l'une quelconque des revendications 1 à 10, l'ouverture (45) d'une lamelle étant sensiblement égale au tiers de la largeur interne (L) du guide d'onde (1).

12. Dispositif selon l'une quelconque des revendications précédentes, le guide d'onde (1) comportant une trappe d'accès (55) fermant une ouverture (56) percée sur une face longitudinale (3, 4).

13. Dispositif selon l'une quelconque des revendications précédentes, l'entrée du guide (46) étant reliée, par un guide de transition évasé (27), à un circuit d'amenée (21, 23) de l'onde formant le rayonnement hyperfréquence.

14. Dispositif selon l'une quelconque des revendications précédentes, la sortie du guide (47) étant reliée, par un guide de transition évasé (28), à un circuit (22, 26) du rayonnement hyperfréquence.

15. Procédé de test de vulnérabilité d'une cible (31) à un rayonnement hyperfréquence, comprenant les étapes suivantes:

- mettre en place un dispositif selon l'une quelconque des revendications précédentes, et
- placer la cible dans l'espace disponible (5) dudit dispositif.

16. Procédé selon la revendication 15, **caractérisé en ce que** la cible (31) est un matériel en fonctionnement.

**Patentansprüche**

1. Vorrichtung zum Erzeugen von Mikrowellenstrahlung in Richtung eines Ziels (31), die wenigstens einen rechteckigen Wellenleiter (1) umfasst, der von zwei longitudinalen Wänden (3, 4) und zwei lateralen Wänden (6, 7) gebildet wird, indem er die Mikrowellenstrahlung leitet, versehen mit internen leitenden Lamellen (2), die parallel zu den longitudinalen Wänden (3, 4) platziert sind, wobei die leitenden Lamellen eine Öffnung (45) zum Bilden eines verfügbaren Raums (5) haben, der das Ziel (31) aufnehmen kann.

2. Vorrichtung nach Anspruch 1, wobei die Strahlung in einem gegebenen Frequenzband emittiert wird, wobei die Distanz (d) zwischen den Lamellen (2) geringer ist als die halbe Wellenlänge ($\lambda_{18}$) der höchsten Frequenz des Bandes.

3. Vorrichtung nach einem der vorherigen Ansprüche, wobei die Strahlung in einem gegebenen Frequenzband ausgesendet wird, wobei die Innenbreite (L) des Wellenleiters (1) gleich oder größer als die halbe Wellenlänge ($\lambda_1$) der tiefsten Frequenz des Bandes ist.

4. Vorrichtung nach einem der vorherigen Ansprüche, wobei die Öffnung (45) einer Lamelle an der Seite des Eingangs (46) des Leiters (1) mit einer Aufweitung (43) beginnt.

5. Vorrichtung nach Anspruch 4, wobei die Aufweitung (43) in einer gegebenen Distanz ($L_e$) vom Eingang (46) des Leiters beginnt.

6. Vorrichtung nach einem der vorherigen Ansprüche, wobei die Öffnung (45) einer Lamelle mit einer Aufweitung (44) auf der Ausgangsseite des Leiters (1) schließt.

7. Vorrichtung nach einem der vorherigen Ansprüche, wobei der Wellenleiter (1) durch Zusammenfügen von zwei Halbwellenleitern (51, 52) zu einer U-Form gebildet wird.

8. Vorrichtung nach einem der vorherigen Ansprüche, wobei die Lamellen (2) paarweise an den lateralen Wänden (6, 7) des Leiters (1) fixiert sind, wobei ein Lamellenpaar eine U-Form hat.

9. Vorrichtung nach den Ansprüchen 7 und 8, wobei ein U-förmiges Paar zwei Halblamellen (41, 42) umfasst, wobei eine Lamelle (2) durch Zusammenfügen von zwei Halbwellenleitern (51, 52) gebildet wird.

10. Vorrichtung nach einem der vorherigen Ansprüche, wobei die Öffnung (45) einer Lamelle im Wesentlichen gleich der Hälfte der Innenbreite (L) des Wellenleiters (1) ist.

11. Vorrichtung nach einem der Ansprüche 1 bis 10, wobei die Öffnung (45) einer Lamelle im Wesentlichen gleich einem Drittel der Innenbreite (L) des Wellenleiters (1) ist.

12. Vorrichtung nach einem der vorherigen Ansprüche, wobei der Wellenleiter (1) eine Zugangsluke (55) umfasst, die eine auf einer longitudinalen Fläche (3, 4) gebohrte Öffnung (56) schließt.

13. Vorrichtung nach einem der vorherigen Ansprüche, wobei der Eingang (46) des Leiters über eine aufgeweitete Übergangsführung (27) mit einem Speisekreis (21, 23) der die Mikrowellenstrahlung bildenden Welle verbunden ist.

14. Vorrichtung nach einem der vorherigen Ansprüche, wobei der Ausgang (47) des Leiters über einen aufgeweiteten Übergangsleiter (28) mit einem Kreis (22, 26) der Mikrowellenstrahlung verbunden ist.

15. Verfahren zum Prüfen der Empfindlichkeit eines Ziels (31) für eine Mikrowellenstrahlung, das die folgenden Schritte beinhaltet:

- Installieren einer Vorrichtung nach einem der vorherigen Ansprüche; und
- Platzieren des Ziels im verfügbaren Raum (5) der Vorrichtung.

**16.** Verfahren nach Anspruch 15, **dadurch gekennzeichnet, dass** das Ziel (31) Betriebshardware ist.

**Claims**

**1.** A device for generating microwave radiation towards a target (31), comprising at least one rectangular waveguide (1), which is formed by two longitudinal walls (3, 4) and two lateral walls (6, 7), guiding said microwave radiation and being provided with internal conductive strips (2) placed parallel to said longitudinal walls (3, 4), said conductive strips having an opening (45) for forming an available space (5) able to receive the target (31).

**2.** The device according to claim 1, said radiation being emitted in a given frequency band, the distance (d) between said strips (2) being less than the half-wavelength ($\lambda_{18}$) of the highest frequency of the band.

**3.** The device according to any one of the preceding claims, said radiation being emitted in a given frequency band, the internal width (L) of said waveguide (1) being greater than or equal to the half-wavelength ($\lambda_1$) of the lowest frequency of the band.

**4.** The device according to any one of the preceding claims, the opening (45) of a strip starting on the side of the inlet (46) of said guide (1) via a flared section (43).

**5.** The device according to claim 4, said flared section (43) starting at a given distance ($L_e$) from said inlet (46) of said guide.

**6.** The device according to any one of the preceding claims, the opening (45) of a strip closing via a flared section (44) on the outlet side of said guide (1).

**7.** The device according to any one of the preceding claims, said waveguide (1) being formed by assembling two half-waveguides (51, 52) as a U-shape.

**8.** The device according to any one of the preceding claims, said strips (2) being fixed in pairs on said lateral walls (6, 7) of said guide (1), a pair of strips having a U-shape.

**9.** The device according to claims 7 and 8, a U-shaped pair comprising two half-strips (41, 42), a strip (2) being formed by assembling two half-waveguides (51, 52).

**10.** The device according to any one of the preceding claims, the opening (45) of a strip being substantially equal to half of the internal width (L) of said waveguide (1).

**11.** The device according to any one of claims 1 to 10, the opening (45) of a strip being substantially equal to a third of the internal width (L) of said waveguide (1).

**12.** The device according to any one of the preceding claims, said waveguide (1) comprising an access hatch (55) closing an opening (56) perforated on a longitudinal face (3, 4).

**13.** The device according to any one of the preceding claims, said inlet (46) of said guide being connected, via a flared transition guide (27), to a feed circuit (21, 23) of the wave forming said microwave radiation.

**14.** The device according to any one of the preceding claims, said outlet (47) of said guide being connected, via a flared transition guide (28), to a circuit (22, 26) of said microwave radiation.

**15.** A method for testing the susceptibility of a target (31) to microwave radiation, comprising the following steps:

- installing a device according to any one of the preceding claims; and
- placing said target in the available space (5) of said device.

**16.** The method according to claim 15, **characterised in that** said target (31) is operating hardware.

FIG.1

FIG.2

EP 1 895 310 B1

FIG.3

FIG.4

FIG.5a

FIG.5b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20030051666 A1